Europäisches Patentamt

European Patent Office

Office européen des brevets

(19)

(11) EP 0 442 321 B1

(12) EUROPÄISCHE PATENTSCHRIFT

(45) Veröffentlichungstag und Bekanntmachung des Hinweises auf die Patenterteilung:
09.07.1997 Patentblatt 1997/28

(51) Int Cl.6: **H03M 1/14**, H03M 1/36

(21) Anmeldenummer: 91101145.0

(22) Anmeldetag: 29.01.1991

(54) **Analog-Digital-Umsetzer nach dem erweiterten Parallelverfahren**

Extended flash analog-digital converter

Convertisseur analogique-numérique simultané étendu

(84) Benannte Vertragsstaaten:
AT BE CH DE FR GB IT LI LU NL SE

(30) Priorität: 14.02.1990 DE 4004545

(43) Veröffentlichungstag der Anmeldung:
21.08.1991 Patentblatt 1991/34

(73) Patentinhaber: SIEMENS AKTIENGESELLSCHAFT
80333 München (DE)

(72) Erfinder:
• Petschacher, Reinhard, Dipl.-Ing.
A-09500 Villach (AT)
• Astegher, Berthold, Dipl.-Ing.
A-9020 Klagenfurt (AT)

(56) Entgegenhaltungen:
US-A- 3 721 975     US-A- 3 909 719
US-A- 4 862 171

**Beschreibung**

Die Erfindung betrifft einen Analog-Digital-Umsetzer nach dem Oberbegriff des Patentanspruches 1.

Kurze Wandlungszeiten einerseits und hohe Auflösung andererseits sind bei der Realisierung von Analog-Digital-Umsetzern zwei nur schwer zu vereinbarende Forderungen. Umsetzer, mit hoher Auflösung, wie beispielsweise nach dem Zahlverfahren oder dem Wägeverfahren arbeitende Umsetzer, haben meist relativ lange Wandlungszeiten, während Umsetzer mit sehr kurzen Wandlungszeiten, wie beispielsweise nach dem Parallelverfahren arbeitende Umsetzer, in der erzielbaren Auflösung dadurch beschränkt sind, daß der notwendige Schaltungsaufwand in etwa exponentiell mit der Ausgangswortlänge ansteigt. Für einen 10 Bit-Umsetzer benötigt man beispielsweise bereits 1023 Komparatoren. Man kann diesen Aufwand wesentlich reduzieren, indem man Zugeständnisse an die Umwandlungsgeschwindigkeit macht. Dazu kombiniert man das Parallelverfahren mit dem Wägeverfahren.

Einen 10 Bit-Umsetzer nach diesem erweiterten Parallelverfahren realisiert man beispielsweise dadurch, daß man in einem ersten Schritt die oberen 5 Bit parallel umwandelt. Das Ergebnis stellt den grob quantisierten Wert der Eingangsspannung dar. Mit einem Digital-Analog-Umsetzer bildet man die zugehörige Analog-Spannung und subtrahiert diese von der Eingangsspannung. Der verbleibende Rest wird mit einem weiteren Analog-Digital-Umsetzer digitalisiert.

Grob- und Feinwerte müssen natürlich jeweils von derselben Eingangsspannung gebildet werden. Wegen der Laufzeit durch den ersten Analog-Digital-Umsetzer und den Digital-Analog-Umsetzer entsteht jedoch eine zeitliche Verzögerung. Deshalb muß die Eingangsspannung bei diesem Verfahren mit einem analogen Abtast-Halte-Glied konstant gehalten werden, bis die ganze Zahl gebildet ist. Das Prinzip eines Analog-Digital-Umsetzers nach dem erweiterten Parallelverfahren ist beispielsweise in U. Tietze, Ch. Schenk, Halbleiterschaltungstechnik, 7. Auflage 1985, Seiten 765-767 beschrieben. Darüber hinaus sind gattungsgemäße Analog-Digital-Umsetzer aus den US-Patentschriften 3,721,975 und 4,862,171 bekannt.

Die Anforderungen an die Analog-Digital-Umsetzer sind bei diesem Schaltungsprinzip zwar niedriger, jedoch muß der Digital-Analog-Umsetzer die volle Genauigkeit, also beispielsweise die volle 10 Bit-Genauigkeit, aufweisen. Um die geforderte Genauigkeit zu erzielen, ist daher irgendeine Form von Abgleich notwendig. Gerade aber bei integrierten Schaltungen, insbesondere bei monolithisch integrierten Schaltungen, ist ein Abgleich, in welcher Form auch immer, problematisch und meist mit einem erheblichen zusätzlichen Aufwand verbunden.

Aufgabe der Erfindung ist es daher, einen Analog-Digital-Umsetzer der eingangs genannten Art anzugeben, bei dem kein Abgleich notwendig ist.

Diese Aufgabe wird bei einem gattungsgemäßen Analog-Digital-Umsetzer durch die kennzeichnenden Merkmale des Patentanspruches 1 gelöst. Ausgestaltungen und Weiterbildungen des Erfindungsgedankens sind in Unteransprüchen gekennzeichnet.

Der Vorteil eines erfindungsgemäßen Analog-Digital-Umsetzers ist, daß sich der schaltungstechnische Aufwand trotz des Wegfalls von Abgleichmaßnahmen im wesentlichen nicht erhöht.

Die Erfindung wird nachfolgend anhand der in den Figuren der Zeichnung dargestellten Ausführungsbeispiele näher erläutert.
Es zeigt:

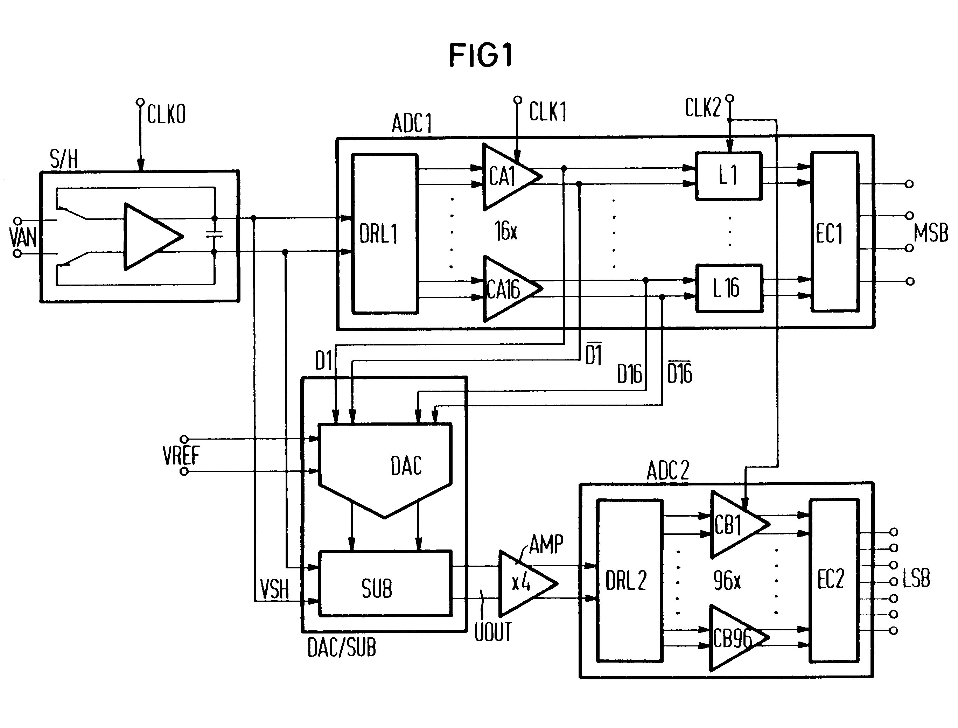

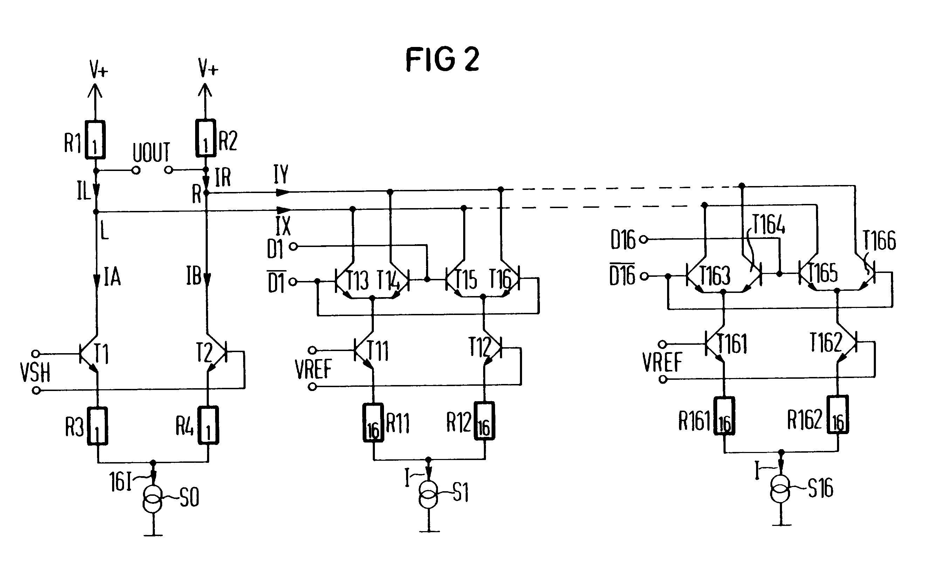

Figur 1 eine grundsätzliche Ausführungsform eines erfindungsgemäßen Analog-Digital-Umsetzers und Figur 2 eine bevorzugte Ausführungsform eines Subtrahierers und Digital-Analog-Umsetzers bei einem erfindungsgemäßen Analog-Digital-Umsetzer.

Ein erfindungsgemäßer Analog-Digital-Umsetzer nach FIG 1 der Zeichnung weist ein Abtast-Halte-Glied S/H, einen nach dem Parallelverfahren arbeitenden ersten Analog-Digital-Umsetzer ADC1, einen nach dem Parallelverfahren arbeitenden zweiten Analog-Digital-Umsetzer ADC2, einen subtrahierenden Digital-Analog-Umsetzer DAC/SUB und einen Verstärker AMP auf. Mit dem Abtast-Halte-Glied S/H wird, durch einen Takt CLKO gesteuert, ein analoges symmetrisches Eingangssignal VAN gespeichert. Die Ausgänge -der invertierte und der nicht invertierte Ausgang- des Abtast-Halte-Glieds S/H sind mit den entsprechenden Eingängen des ersten Analog-Digital-Umsetzers ADC1 und des subtrahierenden Digital-Analog-Umsetzers DAC/SUB verbunden. Bei diesen Eingängen handelt es sich aufgrund der Symmetrie ebenso wie bei den Eingängen des Abtast-Halte-Glieds S/H um Differenzeingänge. Der Analog-Digital-Umsetzer ADC1 besteht aus einem ersten symmetrischen Widerstandsnetzwerk DRL1, dem die Differenzeingänge von 16 durch einen Takt CLK1 gesteuerte erste Komparatoren CA1...CA16 nachgeschaltet sind.

Jedem der ersten Komparatoren CA1...CA16 folgt ein durch einen Takt CLK2 gesteuertes Speicherelement L1...L16. Die Ausgänge der Speicherelemente L1...L16 sind auf einen Prioritätsdekoder EC1 geführt. Die Eingänge der Speicherelemente L1...L16 und des Prioritätsdekoders EC1 sind ebenso wie die Ausgänge der Speicherelemente L1...L16 als Differenzeingänge bzw. Differenzausgänge ausgebildet. Die Differenzausgänge der ersten Komparatoren CA1... CA16 sind zudem an die Differenzeingänge eines Digital-Analog-Konverters DAC angeschlossen. Der Digital-Analog-Umsetzer DAC bildet zusammen mit dem ihm nachgeschalteten Subtrahierer SUB den subtrahierenden Digital-Analog-Umsetzer DAC/SUB. An den Digital-Analog-Umsetzer DAC ist eine symmetrische Referenzspannung VREF ebenso wie an das symmetrische Widerstandsnetzwerk DRL1 angelegt. Der Subtrahierer SUB ist außer mit den Ausgangssignalen des Digital-Analog-Umsetzers DAC mit den Ausgangssignalen des Abtast-Halte-Glieds S/H beaufschlagt. Dem Subtrahierer SUB ist ein Verstärker AMP mit der Verstärkung 4 nachgeschaltet, der ebenfalls Differenzeingänge und Differenzausgänge aufweist. Dem Verstärker AMP folgt ein zweites symmetrisches Widerstandsnetzwerk DRL2, an dem auch die symmetrische Refferenzspannung VREF angelegt ist. Die Differenzausgänge des symmetrischen Widerstandsnetzwerkes DRL2 sind mit zweiten Komparatoren CB1...CB96 beschaltet, die mit dem Takt CLK2 gesteuert werden. Die Differenzausgänge der Komparatoren CB1...CB96 sind auf einen zweiten Prioritätsdekoder EC2 geführt. Das symmetrische Widerstandsnetzwerk DRL2, die zweiten Komparatoren CB1...CB96 und der zweite Prioritätsdekoder EC2 bilden den zweiten Analog-Digital-Umsetzer ADC2. An den unsymmetrischen Ausgängen der beiden Prioritätsdekoder EC1, EC2 liegen die höherwertigen und niederwertigen Bits MSB und LSB des Wandlungsergebnisses an.

FIG 2 der Zeichnung zeigt eine bevorzugte Ausführungsform eines subtrahierenden Digital-Analog-Umsetzers DAC/SUB. Als Subtrahierer SUB ist dabei eine Differenzverstärkerstufe mit zwei npn-Transistoren T1, T2 vorgesehen, deren Kollektoren jeweils über einen Widerstand R1 und R2 mit einem positiven Versorgungspotential V+ und deren Emitter jeweils über einen Widerstand R3 bzw. R4 mit einer auf ein Bezugspotential führenden Stromeinprägung S0 verbunden sind. Die Basen der beiden Transistoren T1 und T2 bilden die Differenzeingänge des Substrahierers SUB, an denen, wie in FIG 1 der Zeichnung gezeigt, das symmetrische Ausgangssignal VSH des Abtast-Halte-Glieds S/H anliegt. Bei dem Digital-Analog-Umsetzer DAC handelt es sich wie beim Analog-Digital-Umsetzer ADC1 um einen 4 Bit-Umsetzer, der allerdings nicht mit einem 4 Bit-Binärcode angesteuert wird, sondern mit einem x aus $2^N$-Code Thermometercode, wobei N der Zahl der Bits des zugehörigen Binärcodes entspricht. Im vorliegenden Ausführungsbeispiel wird der Digital-Analog-Umsetzer DAC demnach mit 16 symmetrischen Eingangssignalen D1...D16, $\overline{D1}$...$\overline{D16}$ angesteuert, die, wie aus FIG 1 der Zeichnung ersichtlich ist, direkt an den Ausgängen der Komparatoren CA1...CA16 des Analog-Digital-Umsetzers ADC1 abgenommen wird.

Der Digital-Analoc-Kcnverter DAC besteht aus 16 identisch aufgebauten Differenzverstärkerstufen. Jede dieser Stufen weist eine Stromeinprägung S1...S16 auf, die einerseits an Eezugspctential gelegt ist und andererseits über jeweils einen Widerstand R11...R161 bzw. R12...R162 mit jeweils einem npn-Transistor T11...T161 bzw. T12...T162 verbunden ist. Die Basen dieser beiden Transistoren T11...T161 und T12...T162 bilden die Differenzeingänge, an denen die symmetrische Referenzspannung VREF, wie auch in FIG 1 gezeigt, angelegt ist. Der Kollektor des Transistors T11...T161 ist auf die gekoppelten Emitter zweier, ein erstes Transistorpaar bildender npn-Transistoren T13...T163 und T14...T164 geführt. Ebenso ist der Kollektor des Transistors T12...T162 auf die gekoppelten Emitter zweier, ein zweites Transistorpaar bildender npn-Transistoren T15...T165 und T16...T166 geführt. Die Basen von jeweils einem Transistor bei beiden Transistorpaaren sind miteinander gekoppelt und mit dem jeweiligen Eingangssignal D1...D16 beaufschlagt. Die Basen der beiden anderen Transistoren sind ebenfalls miteinander gekoppelt und mit dem jeweiligen invertierten Eingangssignal $\overline{D1}$...$\overline{D16}$ beaufschlagt. Außerdem sind die Kollektoren der Transistoren des ersten Transistorpaares überkreuz mit den entsprechenden Transistoren des zweiten Transistorpaares gekoppelt. Für das vorliegende Ausführungsbeispiel bedeutet dies, daß die Basis des Transistors T13...T163 mit der Basis des Transistors T16...T166 verbunden ist und an beide Basen das invertierte Eingangssignal $\overline{D1}$...$\overline{D16}$ angelegt ist. Folglich sind die Basen von Transistor T14...T164 und Transistor T15...T165 miteinander verschaltet und mit dem Eingangsignal D1...D16 beaufschlagt. Schließlich sind die Kollektoren der Transistoren T13...T163 und T15...T165 miteinander und mit dem Kollektor des Transistors T1 einen Knotenpunkt L bildend verbunden, ebenso wie die Transistoren T14...T164 und T16...T166 einen Knotenpunkt R bildend kollektorseitig zusammengeschaltet und mit dem Kollektor des Transistors T2 verbunden sind. Von dem positiven Versorgungspotential V+ fließt in den Knoten L ein Strom IL und in den Knoten R ein Strom IR. Aus dem Knoten L fließt zum Transistor T1 ein Strom IA und zum Digital-Analog-Umsetzer ein Strom IX, während aus dem Knoten R ein Strom IB zum Transistor T2 und zum Digital-Analog-Umsetzer ein Strom IY fließt.

Die Stromeinprägungen S1...S16 liefern aufgrund ihres identischen Aufbaus den gleichen Konstantstrom I. Die Stromeinprägung S0 ist so dimensioniert, daß sie den $2^N$fachen Strom liefert, das heißt in diesem Falle den 16fachen Strom I. Die Widerstände R1 bis R4 sind untereinander identisch ausgeführt, wie auch die Widerstände R11, R12...R161, R162, wobei letztere jeweils den 16fachen Wert gegenüber den Widerständen R1 bis R4 aufweisen. In diesem Zusammenhang sei auch daraufhingewiesen, daß alternativ zur gezeigten Ausführungsform der Subtrahierer SUB auch derart ausgelegt werden kann, daß $2^N$= 16 identische Subtrahierstufen parallelgeschaltet werden, deren Widerstände und deren Stromeinprägungen die gleichen Werte wie die Widerstände und Stromeinprägungen des Digital-Analog-Umsetzers DAC aufweisen.

Der Subtraktionsvorgang zwischen Analogsignal und rückgewandeltem Signal in einer als Subtrahierer SUB verwendeten Verstärkerschaltung wird durch die Addition je zweier Ströme IA, IX und IB, IY realisiert, wobei ein Ausgangsstrom IL oder IR der Verstärkerschaltung proportional mit der Eingangsspannung VSH ansteigt, während der Strom IX oder IY des Digital-Analog-Umsetzers mit zunehmenden VSH sinkt. Das Subtraktionsergebnis ist durch die über die Widerstände R1 und R2 fließenden Ströme IE und IR gegeben. Beiden Strömen ist jedoch ein Gleichanteil überlagert. Bei symmetrischer Ausführung der Schaltung, wie dies in Weiterbildung der Erfindung im Ausführungsbeispiel gezeigt ist, ist dieser Gleichanteil jedoch im wesentlichen ohne Bedeutung, so daß ein zwischen den Knotenpunkten L und R anliegendes symmetrisches Ausgangssignal UOUT das Subtraktionsergebnis darstellt. Wesentlich dafür ist, daß die Steigung des Stromes IA bzw. IB exakt mit der mittleren Steigung des Ausgangsstromes IL bzw. IR übereinstimmt, damit der Gleichanteil der Ausgangsströme IL und IR unabhängig von der Eingangsspannung VSH ist und keine Verkrümmung der Wandlungskennlinie bewirkt. Um dies zu erreichen, wird allgemein üblicherweise irgendeine Form von Abgleich vorgesehen.

Um nun jedoch Abgleichmaßnahmen zu umgehen, wird für den Digital-Analog-Umsetzer DAC die gleiche Referenzspannung VREF verwendet wie sie auch bei der Quantisierung durch den Analog-Digital-Umsetzer ADC1 eingesetzt wird. Der im vorliegenden Ausführungsbeispiel gezeigte Digital-Analog-Umsetzer besteht, da es sich um einen 4 Bit-Umsetzer handelt, aus 16 gleichartigen Stufen, die über Stromeinprägungen S1...S16 mit dem Strom I versorgt werden. Mit Hilfe der symmetrischen Referenzspannung VREF wird dieser Strom I jeweils in zwei Teilströme aufgespalten, die nun von den Eingangssignalen D1, $\overline{D1}$ ...D16, $\overline{D16}$ entweder auf den Ausgangsknoten L oder auf den Ausgangsknoten R aufgeschaltet werden können. Über den Differenzverstärker mit den Transistoren T1 und T2, sowie den Widerständen R1 bis R4 und der Stromeinprägung S0 mit einen Strom 16 I werden aus der symmetrischen Eingangsspannung VSH die beiden dazu proportionalen Ströme 1A und IB gewonnen. Bei Anwendungsfällen bei denen nur eine ungerade Anzahl von Digitalsignalen vorgesehen ist, wird zusätzlich noch eine Symmetrierstufe hinzugesetzt. Diese ist identisch mit den anderen Stufen des Digital-Analog-Umsetzers DAC aufgebaut. Die beiden Differenzeingänge dieser Stufe werden miteinander verschaltet und auf ein Potential gelegt, das zwischen dem höchsten und dem niedrigsten Pegel des digitalen Eingangssignals liegt. Wäre also beispielsweise der Digital-Analog-Umsetzer DAC nur mit 15 Eingangssignalen beaufschlagt, so würden die Eingänge für die digitalen Signale D16 bzw. $\overline{D16}$ auf ein unsymmetrisches Potential gelegt, das beispielsweise gleich dem Mittelwert von minimalem und dem maximalem Pegel der übrigen Eingangssignale G1, $\overline{G1}$ ...G15, $\overline{G15}$ ist. Desweiteren besteht die Möglichkeit zwischen den Knoten L bzw. R und dem Kollektor des Transistors T1 bzw. T2 eine aus zwei Transistoren bestehende Kaskodestufe zu setzen, welche basisseitig ebenfalls mit diesem unsymmetrischen Potential verbunden ist. Im gezeigten Ausführungsbeispiel erfolgt jedoch die Ansteuerung der Symmetrierstufe durch einen zusätzlichen Komparator, nämlich den Komparator CA16 des Analog-Digital-Umsetzers ADC1. Für einen 4-Bit-Umsetzer, beispielsweise den Analog-Digital-Umsetzer ADC1, wären prinzipiell aber nur 15 Komparatoren notwendig. Der zusätzliche Komparator spricht auf die dem symmetrischen Widerstandsnetzwerk DRL1 überlagerte Gleichspannung an. Abgleichmaßnahmen sind zudem deshalb nicht notwendig, weil der Digital-Analog-Umsetzer DAC nicht durch die im Binärcode vorliegenden Ausgangssignale angesteuert wird, wodurch beispielsweise eine binäre Abstufung beim Digital-Analog-Umsetzer DAC notwendig würde, sondern durch die Ausgangssignale der einzelnen Komparatoren des Analog-Digital-Umsetzers ADC1. Dadurch sind keine binären Abstufungen erforderlich, sondern lediglich identisch aufgebaute Stufen. Ein identischer Aufbau ist wesentlich exakter durchzuführen und damit wesentlich geringeren Schwankungen unterworfen. Darüber hinaus können die einzelnen Stufen des Digital-Analog-Umsetzers DAC auch an die einzelnen Komparatoren des Analog-Digital-Umsetzers ADC in ihrem Aufbau angepaßt werden können.

## Patentansprüche

1. Analog-Digital-Umsetzer mit einem nach dem Parallelverfahren arbeitenden, Komparatoren (CA1... CA16) aufweisenden ersten Analog-Digital-Umsetzer (ADC1) mit N-Bit-Auflösung, dem ein Abtast-Halte-Glied (S/H) vorgeschaltet ist und mit einem nach dem Parallelverfahren arbeitenden, Komparatoren (CB1...CB96) aufweisenden zweiten Analog-Digital-Umsetzer (ADC2) mit M-Bit-Auflösung dem ein mit dem Digital-Analog-Umsetzer (DAC) und dem Abtast-Halte-Glied (S/H) verbundener Subtrahierer (SUB) mit Verstärker (AMP) vorgeschaltet ist, wobei die Ausgangssignale der Komparatoren (CA1...CA16) des ersten Analog-Digital-Umsetzers (ADC1) mittels eines Thermometer-Codes direkt zur Ansteuerung des Digital-Analog-Wandlers (DAC) vorgesehen sind,
**dadurch gekennzeichnet,** daß an dem ersten Analog-Digital-Umsetzer (ADC1) und dem Digital-Analog-Wandler (DAC) die gleiche Referenzspannung (VREF) anliegt und daß eine symmetrische Signalverarbeitung bei dem Abtast-Halte-Glied (S/H), bei erstem und zweitem Analog-Digital-Umsetzer (ADC1), bei dem Digital-Analog-Umsetzer (DAC) und/oder bei dem Subtrahierer (SUB) sowie eine symmetrische Referenzspannung (VREF) vorgesehen sind.

2. Analog-Digital-Wandler nach Anspruch 1,
**dadurch gekennzeichnet,** daß Digital-Analog-Umsetzer (DAC) und Subtrahierer (SUB) zusammengefaßt sind und aus einer ersten Differenzverstärkerstufe (T1, T2, R3, R4, S0), an deren Differenzeingangen das symmetrische Ausgangssignal (VHS) des Abtast-Halte-Glieds (S/H) angelegt ist, sowie aus einer der Anzahl der Komparatoren des ersten Analog-Digital-Umsetzers (ADC1) entsprechenden Anzahl von zweiten Differenzverstärkerstufen (R11...R161, R12...R162, S1...S16, T11...T161, T12...T162) in deren Ausgangsleitungen sich jeweils durch die Komparatoren angesteuerte und kreuzgekoppelte dritte und vierte Differenzverstärkerstufen (T13...T161, T14...T164, T15...T165, T16...T166) befinden, besteht,

daß die Ausgangsleitungen von ersten und zweiten Differenzverstarkerstufen auf gemeinsame Lastwiderstände (R1, R2) geführt sind und

daß die Speiseströme der zweiten Differenzverstärker (R1...R161, R12...R162, S1...S16, T11...T161, T12...T162) untereinander gleich sind und der Speisestrom der ersten Differenzverstärkerstufe (T1, T2, R3, R4, S0) gleich der Summe der Speiseströme der zweiten Differenzverstärker (R11...R161, R12...R162, S1... S16, T11...T161, T12...T162) ist.

3. Analog-Digital-Umsetzer nach Anspruch 2, **dadurch gekennzeichnet,** daß der erste Differenzverstärker (T1, T2, R3, R4, S0) aus einer Anzahl von parallelgeschalteten weiteren Differenzverstärkern besteht, die gleich der Anzahl der Stufen des Digital-Analog-Umsetzers (DAC) ist.

4. Analog-Digital-Umsetzer nach einem der Ansprüche 2 oder 3, **dadurch gekennzeichnet,** daß die ersten und zweiten Differenzverstärker (T1, T2, R3, R4, S0, (R11...R161, R12...R162, S1...S16, T11...T161, T12...T162) Gegenkopplungswiderstände (R3, R4, R11...R161, R12...R162) aufweisen.

5. Analog-Digital-Umsetzer nach einem der Ansprüche 2 bis 4, **dadurch gekennzeichnet,** daß bei dem oder den ersten Differenzverstärker(n) (T1, T2, R3, R4, S0) an einem weiteren Referenzpotential angeschlossene Kaskodestufen in den Ausgangsleitungen vorgesehen sind.

6. Analog-Digital-Umsetzer nach einem der Ansprüche 2 bis 5, **dadurch gekennzeichnet,** daß die dritte und die vierte Differenzverstärkerstufe von einer der zweiten Differenzverstärkerstufen basisseitig an das weitere Referenzpotential angeschlossen sind.

## Claims

1. Analogue/digital converter having a first analogue/digital converter (ADC1) which operates using the parallel method, has comparators (CA1...CA16) and has N-bit resolution, upstream of which a sample and hold element (S/H) is connected, and having a second analogue/digital converter (ADC2) which operates using the parallel method, has comparators (CB1...CB96) and has M-bit resolution, upstream from which a subtracter (SUB) is connected which is connected to the digital/analogue converter (DAC) and to the sample and hold element (S/H) and has an amplifier (AMP), the output signals from the comparators (CAT...CA16) of the first analogue/digital converter (ADC1) being provided directly by means of a thermometer code for driving the digital/analogue converter (DAC), characterized in that the same reference voltage (VREF) is applied to the first analogue/digital converter (ADC1) and to the digital/analogue converter (DAC), and in that symmetrical signal processing is provided in the sample and hold element (S/H), in the first and the second analogue/digital converter (ADC1 and ADC2), in the digital/analogue converter (DAC) and/or in the subtracter (SUB), and a symmetrical reference voltage (VREF) is provided.

2. Analogue/digital converter according to Claim 1, characterized in that the digital/analogue converter (DAC) and subtracter (SUB) are combined and comprises a first differential amplifier stage (T1, T2, R3, R4, S0), to whose differential inputs the symmetrical output signal (VHS) of the sample and hold element (S/H) is applied, as well as comprising a number of second differential amplifier stages (R11...R161, R12...R162, S1...S16, T11...T161, T12...T162), the number of which corresponds to the number of comparators in the first analogue/digital converter (ADC1), and in whose output lines third and fourth differential amplifier stages (T13...T161, T14...T164, T15...T165, T16...T166) are located which are in each case driven by the comparators and are cross-coupled, in that the output lines of the first and second differential amplifier stages are passed to common load resistors (R1, R2), and in that the supply currents of the second differential amplifiers (R1...R161, R12...R162, S1...S16, T11...T161, T12...T162) are identical to one another, and the supply current of the first differential amplifier stage (T1, T2, R3, R4, S0) is equal to the sum of the supply currents of the second differential amplifiers (R11...R161, R12...R162, S1...S16, T11...T161, T12...T162).

3. Analogue/digital converter according to Claim 2, characterized in that the first differential amplifier (T1, T2, R3, R4, S0) comprises a number of parallel-connected further differential amplifiers, the number of which is equal to the number of stages of the digital/analogue converter (DAC).

4. Analogue/digital converter according to one of Claims 2 or 3, characterized in that the first and second differential amplifiers (T1, T2, R3, R4, S0, R11...R161, R12...R162, S1...S16, T11...T161, T12...T162) have negative feedback resistors (R3, R4, R11...R161, R12...R162).

5. Analogue/digital converter according to one of Claims 2 to 4, characterized in that cascode stages, which are connected to a further reference potential, are provided in the output lines of the first differential amplifier or amplifiers (T1, T2, R3, R4, S0).

6. Analogue/digital converter according to one of Claims 2 to 5, characterized in that the third and the fourth differential amplifier stage are connected from one of the second differential amplifier stages on the base side to the further reference potential.

## Revendications

1. Convertisseur analogique-numérique composé d'un premier convertisseur analogique-numérique (ADC1) d'une résolution de N bits comportant des comparateurs (CA1...CA16) fonctionnant selon la méthode simultanée, précédé d'un échantillonneur-bloqueur (S/H), et d'un deuxième convertisseur analogique-numérique (ADC2) d'une résolution de M bits comportant des comparateurs (CB1...CB96) fonctionnant selon la méthode simultanée, précédé d'un soustracteur (SUB) avec amplificateur (AMP) relié au convertisseur numérique-analogique (DAC) et à l'échantillonneur-bloqueur (S/H), dans lequel les signaux de sortie des comparateurs (CA1...CA16) du premier convertisseur analogique-numérique (ADC1) doivent, à l'aide d'un code de thermomètre, commander directement le convertisseur numérique-analogique (DAC), caractérisé en ce que la même tension de référence (VREF) est présente au premier convertisseur analogique-numérique (ADC1) et au convertisseur numérique-analogique (DAC) et en ce qu'un traitement symétrique des signaux est prévu pour l'échantillonneur-bloqueur (S/H), le premier et le deuxième convertisseur analogique-numérique (ADC1), le convertisseur numérique-analogique (DAC) et/ou le soustracteur (SUB) et une tension de référence symétrique (VREF) est également prévue.

2. Convertisseur analogique-numérique selon la revendication 1, caractérisé en ce que le convertisseur numérique-analogique (DAC) et le soustracteur (SUB) sont regroupés et se composent d'un premier étage amplificateur différentiel (T1, T2, R3, R4, S0) aux entrées différentielles duquel le signal de sortie symétrique (VHS) de l'échantillonneur-bloqueur (S/H) est présent ainsi que d'un nombre de deuxièmes étages amplificateurs différentiels (R11...R161, R12...R162, S1...S16, T11...T161, T12...T162) correspondant au nombre de comparateurs du premier convertisseur analogique-numérique (ADC1) dans les lignes de sortie desquels se trouvent les troisième et quatrième étages amplificateurs différentiels (T13...T161, T14...T164, T15...T165, T16...T166) commandés par les comparateurs et couplés par croisement,
en ce que les lignes de sortie des premier et deuxième étages amplificateurs différentiels sont amenées à des résistances de charge communes (R1, R2) et en ce que les courants d'alimentation des deuxièmes amplificateurs différentiels (R1...R161, R12...R162, S1...S16, T11...T161, T12...T162) sont identiques entre eux et le courant d'alimentation du premier étage amplificateur différentiel (T1, T2, R3, R4, S0) est égal à la somme des courants d'alimentation des deuxièmes amplificateurs différentiels (R11...R161, R12...R162, S1..S16, T11...T161, T12...T162).

3. Convertisseur analogique-numérique selon la revendication 2, caractérisé en ce que le premier amplificateur différentiel (T1, T2, R3, R4, S0) se compose d'un nombre d'autres amplificateurs différentiels montés en parallèle qui est égal au nombre d'étages du convertisseur numérique-analogique (DAC).

4. Convertisseur analogique-numérique selon l'une des revendications 2 ou 3, caractérisé en ce que les premier et deuxième amplificateurs différentiels (T1, T2, R3, R4, S0, R11... R161, R12...R162, S1...S16, T11...T161, T12... T162) présentent des résistances de contre-réaction (R3, R4, R1... R161, R12... R162).

5. Convertisseur analogique-numérique selon l'une des revendications 2 à 4, caractérisé en ce que, pour le ou les premier(s) amplificateur(s) différentiel(s) (T1, T2, R3, R4, S0) des étages cascodes raccordés à un autre potentiel de référence sont prévus dans les lignes de sortie.

6. Convertisseur analogique-numérique selon l'une des revendications 2 à 5, caractérisé en ce que le troisième et le quatrième étages amplificateurs différentiels de l'un des deuxièmes étages amplificateurs différentiels sont, du côté de la base, raccordés à l'autre potentiel de référence.

# FIG1

EP 0 442 321 B1

FIG 2

EP 0 442 321 B1